Europäisches Patentamt

European Patent Office

Office européen des brevets

(11) Publication number: **0 055 558**

**B1**

(12) **EUROPEAN PATENT SPECIFICATION**

(45) Date of publication of patent specification: **06.08.86**

(21) Application number: **81305941.7**

(22) Date of filing: **18.12.81**

(51) Int. Cl.⁴: **H 01 L 21/225,** H 01 L 29/94, H 01 L 27/10, H 01 L 21/314 // G11C11/24

(54) **Method of manufacturing a semiconductor device.**

(30) Priority: **29.12.80 JP 189056/80**

(43) Date of publication of application: **07.07.82 Bulletin 82/27**

(45) Publication of the grant of the patent: **06.08.86 Bulletin 86/32**

(84) Designated Contracting States: **DE FR GB NL**

(56) References cited:
**DE-A-2 555 187**
**US-A-4 112 575**

**PATENTS ABSTRACTS OF JAPAN, vol. 4, no. 109(E-20)(591), 6th August 1980, page 18E20**
**PATENTS ABSTRACTS OF JAPAN, vol. 2, no. 1, 26th December 1977, page 9395E77**

(73) Proprietor: **FUJITSU LIMITED** · **1015, Kamikodanaka Nakahara-ku Kawasaki-shi Kanagawa 211 (JP)**

(72) Inventor: **Toyokura, Nobuo 1569-1, Shinsaku Takatsu-ku Kawasaki-shi Kanagawa 213 (JP)**
Inventor: **Taguchi, Masao 4-3-4-201, Araisono Sagamihara-shi Kanagawa 228 (JP)**

(74) Representative: **Sunderland, James Harry et al HASELTINE LAKE & CO Hazlitt House 28 Southampton Buildings Chancery Lane London WC2A 1AT (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to a method of manufacturing a semiconductor device such as a Metal-Insulator-Semiconductor (MIS) type capacitor, and more particularly a one transistor type dynamic random access memory.

Currently, efforts are being made to increase the scale and density of integration, or the number of elements per chip, in semiconductor integrated circuits. In semiconductor devices so manufactured with a view to maximising function density, it is necessary to reduce the area occupied by each element of the device. However, with regard to capacitor elements, there is a certain restriction on the degree of reduction of the area occupied by such an element, because, as its area is reduced, the amount of electric charge that can be held in the element is also reduced.

In particular, in the case of a one transistor type memory cell, which contains therein a capacitor element, a reduction of the area of the capacitor element brings about a reduction of the amount of electric charge that can be held therein, and thus a reduction in read signals and a reduction in tolerance for external noise.

In a conventional enhancement mode MIS transistor charging is effective only up to a voltage which is equal to the voltage applied to an upper electrode of a capacitor element minus a threshold voltage under which an inversion layer is formed near that part of the substrate surface having the MIS structure providing the capacitance. If it were possible to charge up to the voltage applied to the upper electrode, an increased amount of electric charge could be held in a capacitor element.

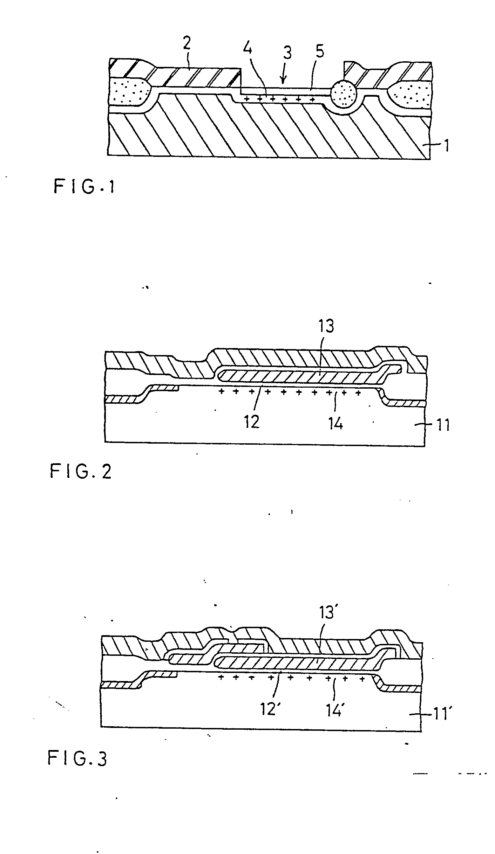

Japanese Patent Publication (unexamined) No. 59384 of 1978, published on 29th May, 1978, discloses an invention entitled "An N-channel MOS silicon gate RAM cell". In that publication, there is disclosed a formation of a region at the surface of a silicon substrate in such a manner that the region is to have a conductivity type which is opposite of the silicon substrate. Referring to Figure 1 of the accompanying drawings, which is a schematic cross-sectional view of a silicon substrate in which a RAM cell is to be formed, a p-type silicon substrate 1 is covered with a photoresist film 2 which has been patterned in a known manner. The photoresist film 2 is exposed to ultraviolet light through a mask which shields a region covering a region where impurity ions are to be implanted. Ions of phosphorus are then driven into the region 3, where a RAM cell is to be fabricated, at 150 KeV, with a dosage of the order of $1 \times 10^{12}/cm^2$. Thus, an n-type region 4 is formed near the surface of the p-type silicon substrate covered with a film 5 silicon dioxide.

Japanese Patent Publication (unexamined) No. 76687 of 1978, published on 7th July 1978, discloses an invention entitled "A semiconductor memory device".

Figures 2 and 3 of the accompanying drawings, which are schematic sectional views, illustrate that ions of phosphorus, with a dosage in the order of $5 \times 10^{12}/cm^2$, are implanted into a p-type silicon substrate 11 or 11' near the surface of the substrate, where a memory element is to be fabricated. As a result, an n-type region 14 or 14' is formed in the substrate 11 or 11' under a gate insulating film 12 or 12' of a memory capacitor on which film is formed a capacitor electrode 13 or 13' of the memory capacitor.

Patent Abstracts of Japan, Vol. 2, No. 1, 26th December 1977, page 939E77, referring to JP—A—52—113 181, discloses the use of a $TiO_2$ film as a dielectric of a capacity element for storing information in a MIS type semiconductor memory device. It is disclosed that the dielectric constant of $TiO_2$ is about 33 times greater than that of $SiO_2$.

DE—A—2 555 187 discloses the formation of layers of oxide of titanium and of aluminium on the surface of a semiconductor.

US—A—4 112 575 concerns the provision of a memory cell which stores charge not only in an oxide capacitor but also in a depletion capacitor. The depletion capacitor is formed with impurities of opposite conductivity types introduced into respective deep and shallow regions of a substrate of the device, which substrate is of the same conductivity type as the impurity in the deep region.

For example in the case of a p-type substrate, a storage region is formed in the substrate by two ion implants: one implant is a relatively deep p-type implant whilst the other is a relatively shallow n-type implant. An insulating layer is formed over the storage region. A storage gate/electrode of a capacitor of the device is formed over the insulating layer.

The insulating layer is of silicon dioxide. No alternative to silicon dioxide is mentioned.

It is disclosed that an alternative to ion implantation into the bare substrate surface (before formation of the silicon dioxide insulating layer) for the relatively shallow n type implant, it is possible to form the silicon dioxide layer after the deep implant step, then to implant n-type impurity into the silicon dioxide layer. A subsequent high temperature step is used to diffuse the impurity from the silicon dioxide layer into the surface of the substrate underlying the silicon dioxide layer.

According to the present invention there is provided a method of manufacturing a semiconductor device having a semiconductur substrate of one conductivity type in which a region of an opposite conductivity type is formed, and having an electrode of a capacitor of the device formed over the substrate spaced apart from the said region, wherein an insulating film principally comprising an oxide or a nitride of at least one of the following metals:— tantalum titanium hafnium niobium zirconium aluminium, and containing impurities of the said opposite conductivity type, is formed on the substrate and the said region of the said opposite conductivity type is formed in the substrate where the insulating film contacts the substrate by diffusion of the said impurities from the insulating film into the substrate.

Embodiments of the present invention can in general offer an MIS type capacitor having improved characteristics, by the employment of a novel process for diffusion of impurities in the capacitor and a new insulating film.

In embodiments of the present invention, an insulating film comprising an oxide or a nitride of any one of the following metals:— Tantalum (Ta), Titanium (Ti), Hafnium (Hf), Niobium (Nb), Zirconium (Zr), Aluminium (Al) is selected to provide the insulating film of an MIS capacitor. By utilising such an insulating film it is possible considerably to increase the amount of electric charge which can be held as compared with a case in which a conventional film of silicon dioxide is used. In other words, accumulation of the same quantity of electric charge may be realised in a capacitor element of smaller size, and this is effective in improving integration density.

In embodiments of the present invention, the said metal oxide or nitride insulating film is doped with impurities of a conductivity type opposite to that of a silicon substrate on which the MIS capacitor is to be fabricated. When the film of doped metal oxide or metal nitride is annealed, the grain size of the film becomes smaller, and this serves to reduce leakage current.

Insulating films as employed in the present invention comprise dielectric materials which possess dielectric constants higher than that of silicon dioxide, which latter material is currently widely used for capacitor element insulating film. The use of an insulating film of higher dielectric constant, as in embodiments of the present invention, will make it possible to reduce the area occupied by a capacitor element without lessening the overall amount of electric charge that can be held therein, by virtue of an increase in capacity per unit area.

Insulating film dielectric materials as provided by the present invention, which possess higher dielectric constants than that of silicon dioxide film, include for example alumina $(Al_2O_3)$, tantalum oxide $(Ta_3O_5)$, titanium oxide $(TiO_2)$ and the like.

These insulating films, however, form surface states due to crystal defects or dangling bonds and capture electric charges in a manner never experienced with conventional silicon dioxide film. Furthermore, in addition to such surface states, charge capturing centres or traps are formed within the insulating films, these traps capturing electric charges by reason of tunnel currents from the surface, and so forth.

Because of the formation of such surface states and the capture of electric charges at traps, an inversion layer is formed at the surface of a silicon substrate as time passes, so that the amount of electric charge that can be accumulated at a capacitor element varies as time passes. Furthermore, electric charges trapped at charge capturing centres are not all discharged at the time of reading of a capacitor element, and this effect is equivalent to a decrease in the amount of electric charge that can be accumulated.

For preventing a decrease in accumulated electric charges (the amount of charge that can be held) due to the trapping of charges at capturing centres, an effective method has been found wherein impurities creating a region of a conductivity type opposite to that of a silicon substrate in respect of which the capacitor element is formed are diffused into a region near the surface of the silicon substrate and under the insulating film of the capacitor element, to form in advance an inversion layer. Further, formation of a region of a conductivity type which is opposite to that of the substrate under the insulating film of the capacitor element is to turn the MIS type capacitor into a depletion mode device. As mentioned above, in a conventional enhancement mode MIS capacitor, charging is effective only up to a voltage which is equal to the voltage applied to an upper electrode of the capacitor (normally connected to a power source) minus a threshold voltage under which an inversion layer is formed near that part of the substrate surface having the MIS structure providing the capacitance. By the method described above it is possible to charge up to the voltage of the power source, and this increases the amount of electric charge that can be accumulated at the capacitor. Now, one of the most difficult problems experienced in the above method, for forming a region of a conductivity type opposite to that of the substrate near the surface of the substrate, is the alignment of the region of opposite conductivity type with the upper electrode of the capacitor element. In other words, if the capacitor electrode extends beyond the region having a conductivity type opposite to that of the substrate, there is created a certain gap in the semiconductor substrate between a transfer gate portion and the capacitor element where the channel is cut off, which gap forms a potential barrier to carriers which charge the capacitor element. Because of this, there is either a voltage loss at the time of writing from a data line or, according to the circumstances, the data line and the capacitor element are not connected via the transfer gate portion. In either case, there is an adverse effect on the operation of, for example, a random access memory using such capacitor elements. Conversely, where the capacitor electrode is within the region of opposite conductivity type which extends under a part of the transfer gate, the effective length of the transfer gate portion is accordingly shortened, and the so-called short channel effect occurs, threshold voltage is reduced, or, according to the circumstances, the data line and the capacitor element are connected by a leakage current due to a punch through phenomenon, thereby causing considerable deterioration of memory retention characteristics. This is also disadvantageous.

Thus in forming the region of opposite conductivity type described above, extreme precision is required for alignment within the capacitor element. However, even in a case in which electron beam exposure is used, misalignment of the order of ±0.2 μm cannot be avoided. This would result in a substantial decrease in manufacturing yield of satisfactory devices.

In embodiments of the present invention problems encountered with an insulating film of high dielectric constant are avoided by forming, near the surface of a semiconductor substrate, a region (an inversion region) of a conductivity type opposite to that of the substrate, through the diffusion of impurities into the substrate. By this means, it is possible to charge a capacitor up to the voltage which is applied to the upper electrode of the capacitor. This serves to increase the amount of electric charge stored in the capacitor at the time of charging.

Further, in embodiments of the present invention, alignment of the inversion region and the electrode of the capacitor, is carried out by diffusion of impurities contained in the insulating film in a self-alignment fashion. Since such alignment is carried out precisely through a process which is much easier than previously proposed processes, the present invention serves to improve the manufacturing yield of MIS capacitors.

Reference is made, by way of example, to the accompanying drawings, in which:—

Figure 1 is a schematic cross-sectional view of a part of a silicon substrate wherein an RAM cell is to be fabricated,

Figures 2 and 3 are respective schematic cross-sectional views each of which shows a part of a silicon substrate on which a semiconductor memory device is to be fabricated,

Figures 4 to 8 are respective schematic cross-sectional views showing a part of a silicon substrate at various stages in the manufacture of an MIS type capacitor in accordance with a method embodying the present invention.

Figures 9 and 10 are graphs for explanation of the results of annealing in accordance with an embodiment of the present invention, and

Figures 11 to 19 are respective schematic cross-sectional views showing a part of a silicon substrate at various stages in the process of manufacture of a one transistor type dynamic random access memory in accordance with a method embodying the present invention.

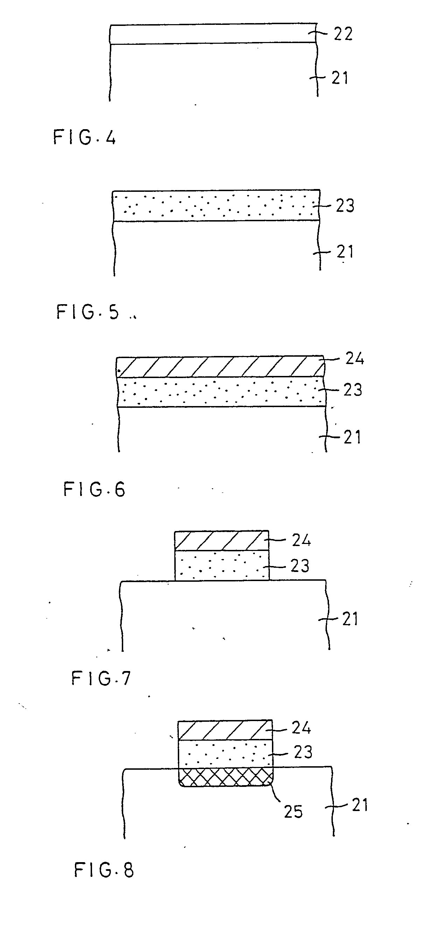

Reference will first be made to Figures 4 to 7 each of which illustrates in cross-section a semiconductor substrate at various stages in the manufacture of an MIS capacitor in accordance with an embodiment of the present invention.

On the surface of a silicon substrate 21, of p-type conductivity, for example, tantalum is deposited, in an atmosphere containing phosphine ($PH_3$) gas, by a conventional double pole sputtering method. By these means, tantalum film 22 containing phosphorus is grown 15 nm to 25 nm thick, as shown in Figure 4, on the silicon substrate 21.

The tantalum film 22 is thoroughly oxidised in at atmosphere containing oxygen ($O_2$) at a temperature of the order of 500 to 700°C, and is converted to an oxidised film 23 comprising tantalum oxide ($Ta_2O_5$), 30 nm to 50 nm thick, as shown in Figure 5. Since this oxidation is carried out at a comparatively low temperature, phosphorus contained in the film 23 of tantalum oxide is not diffused into the silicon substrate 21 nor is the surface of silicon substrate 21 oxidised.

In other embodiments of the presnt invention, however, it is possible to grow a tantalum oxide film 23 directly on the silicon substrate 21 by adding oxygen to the atmosphere mentioned in connection with the sputtering process described with reference to Figure 4. This is an alternative to the oxidation process described with reference to Figure 4.

Next, to form an electrode of an MIS capacitor, a film 24 of molybdenum silicide ($MoSi_x$) is grown approximately 300 nm thick, by conventional double-pole sputtering, as shown in Figure 6. Materials other than molybdenum silicide can be used as electrode material, for example materials such as polycrystal silicon which are capable of withstanding a subsequent process for the diffusion of impurities at a temperature above 900°C may be used.

The tantalum oxide film 23 and molybdenum silicide film 24 are patterned by a conventional process to provide a capacitor element of predetermined shape as illustrated in Figure 7. This may be selectively effected with only one mask by reactive sputter etching using carbon tetrafluoride ($CF_4$) gas and trifluoromethane ($CHF_3$) gas alternately.

Thereafter, a heat treatment is carried out for 30 minutes at a temperature of 1000°C to form a region 25 of n-type conductivity, by diffusing phosphorous contained in the film 23 of tantalum oxide into the surface of the silicon substrate 21 as illustrated in Figure 8.

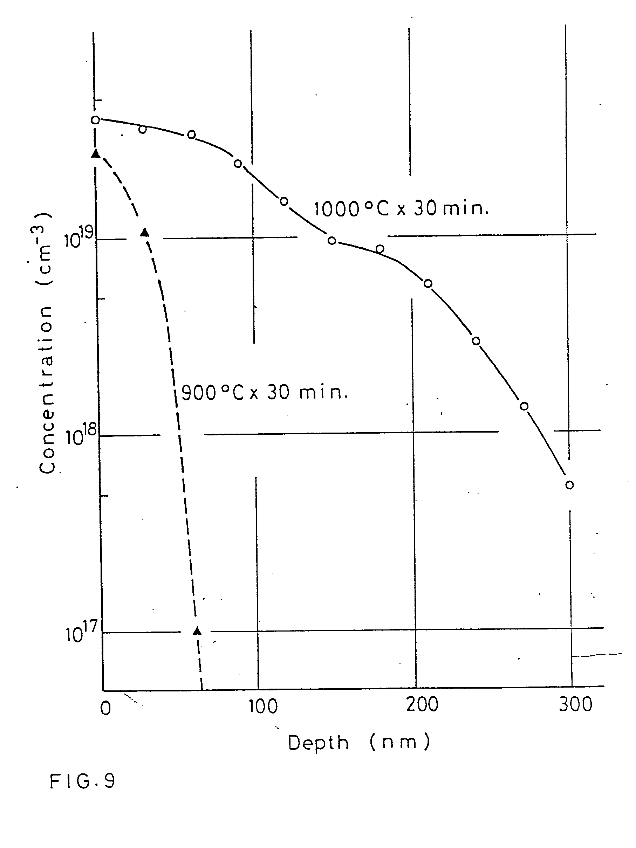

Reference will now be made to the graph of Figure 9 which illustrates diffusion depth (in mm) and concentration (per $cm^3$) obtained by heat treatment as described above. It will be noted that by heat treatment for example at 1000°C for 30 minutes, sufficient impurities are introduced to attain the desired effect with the present invention.

As will be understood from the foregoing description, a metal selected from the following group:— Ta, Ti, Hf, Nb, Zr, Al is oxidised in an embodiment of the invention, and during a step for forming an insulating film of high dielectric constant, impurities contained in the film are not at that stage diffused into the substrate. Impurities are diffused into the substrate only when a subsequent heat treatment is carried out at higher temperature.

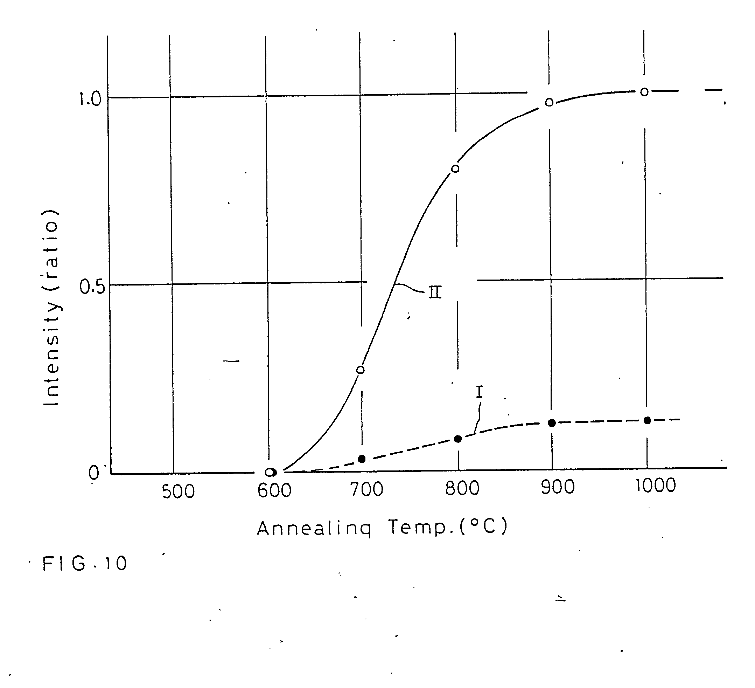

It was found that when phosphorus doped $Ta_2O_5$ film 23 is heat treated, grain size is reduced, which helps to reduce leakage current. This was confirmed by experiments the results of which are shown in the graph of Figure 10.

Samples of phosphorus doped and non-doped $Ta_2O_5$ were heat treated in an oxygen atmosphere for 30 minutes. Then, using a X-ray diffractometer, X-ray diffraction was measured in respect of both samples. Intensity of diffracted X-rays was measured by the counter of the X-ray diffractometer. In the graph of Figure 10, curve I represents data relating to phosphorus doped $Ta_2O_5$, and curve II represents data relating to non-doped $Ta_2O_5$. The fact that curve I shows a lower intensity of X-ray diffraction than curve II indicates that, since grain size of doped $Ta_2O_5$ is smaller than that of non-doped $Ta_2O_5$, there is less X-ray diffraction from the former than from the latter.

By virtue of the heat treatment mentioned above, it is possible to form, in a region where an MIS capacitor is to be fabricated, a region of a conductivity type opposite to that of the substrate, with accurate alignment. In the described embodiment of the invention, a process is described for forming an insulating film of an oxide. However, embodiments of the present invention may employ a process for forming an insulating film of a nitride, in nitrogen atmosphere.

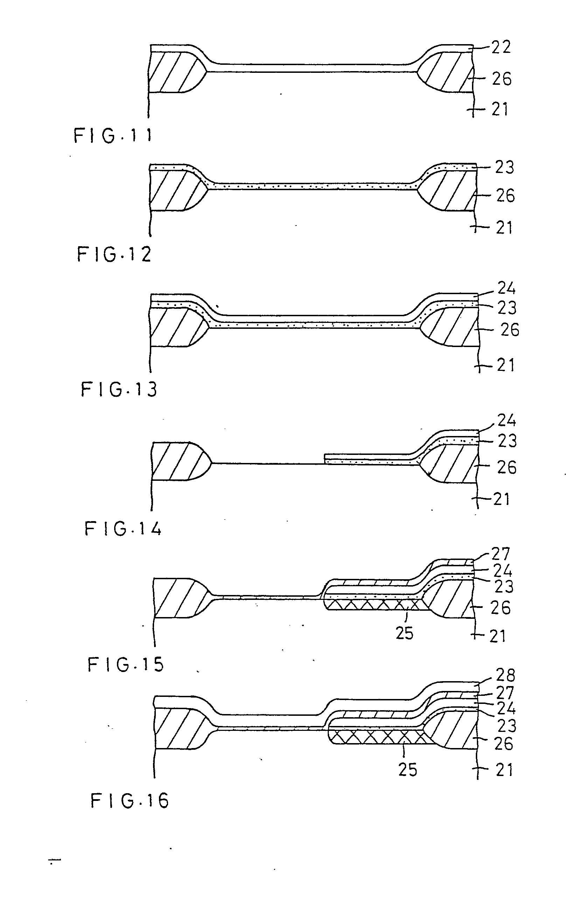

Reference will now be made to Figures 11 to 19 each of which is a cross-section of a part of a silicon substrate, at various stages in the manufacture of a one transistor type dynamic random access memory in accordance with an embodiment of the present invention.

A sufficiently thick oxide film 26, a so-called field oxide film, is formed on a p-type silicon substrate 21 by a conventional selective oxidation process. Next, a tantalum film 22 containing phosphorus is grown to a thickness of 18 nm over the entire surface of the substrate by the same process as explained above with reference to Figure 4. Phosphorus may be included in the film either by reactive sputtering in $PH_3$ gas or by double-pole sputtering using metallic phosphorus and tantalum.

Then, in an oxygen atmosphere, a heat treatment at 500°C is carried out for approximately 20 minutes, thoroughly oxidising the tantalum film 22 to turn it into a $Ta_2O_5$ film 23. At this heat treatment temperature, phosphorus is not diffused into the silicon substrate 21, but remains in $Ta_2O_5$ film 23, its concentration being of the order of $1 \times 10^{18}$ to $1 \times 10^{22}$ $cm^{-3}$ for example, as illustrated in Figure 12.

Then, a $MoSi_x$ film 24, for example, is grown to a thickness of approximately 3000 Å by a known sputtering process, as shown in Figure 13.

Next, $Ta_2O_5$ film 23 and $MoSi_x$ film 24 are so patterned, in a known manner, that these films remain in a predetermined region in which a capacitor element is to be fabricated (Figure 14).

A gate insulation film of the transfer gate portion is formed in a region in which the surface of the silicon substrate 21 is exposed. The entire exposed surface is then oxidised in an oxygen atmosphere, at 950°C for 30 minutes to make a silicon dioxide film 27 approximately 50 nm thick.

Thereby, silicon dioxide film 27 is formed not only on the exposed surface of silicon substrate 21 and the exposed field oxide film 26 but also on the surface and the side of $MoSi_x$ film 24. Thus, $MoSi_x$ film 24, which is to be an upper electrode of an MIS capacitor portion, is completely isolated from its surroundings, as shown in Figure 15. Further, because of this heat treatment at high temperature, part of the phosphorus in the $Ta_2O_5$ film 23 is diffused, in a self-alignment fashion, into the surface of the silicon substrate 21, and a n-type region 25 having a phosphorus concentration of the order of $5 \times 10^{10}$ to $2 \times 10^{15}$ $cm^{-2}$ is formed, only in that part of the silicon substrate 21 which is in contact with the $Ta_2O_5$ film 23, as illustrated in Figure 15. Thus, alignment of the capacitor electrode and the inversion layer can be realised with precision.

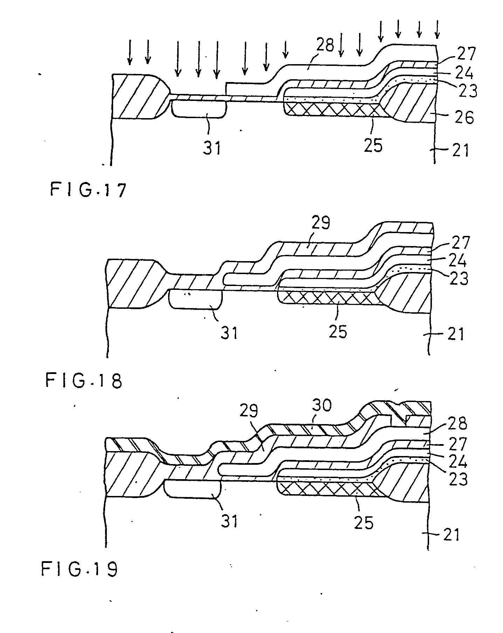

Then, to form an electrode of the transfer gate portion, a polycrystal silicon film 28 is grown to a thickness of approximately 500 nm on $SiO_2$ film 27, as shown in Figure 16. The polycrystal silicon film 28 is then patterned in accordance with the predetermined shape and parts thereof are removed. Ions of arsenic (As) are then implanted into the entire exposed surface by a conventional ion implantation process, at 50 KeV, with a dosage of the order of $1 \times 10^{15}$ $cm^{-2}$. Heat treatment is carried out thereafter to form a data line portion 31. Ions of arsenic thus implanted are diffused by the above described heat treatment to form the data line portion 31 and also to provide donors in the polycrystal silicon film 28, which helps to improve conductivity of the polycrystal silicon film which functions as an electrode of the transfer gate portion (Figure 17).

Thereafter, phosphorus containing PSG (Phospho-Silicate-Glass) film 29, approximately 0.8 µm thick, is formed on $n^+$-type diffusion layer 31 (on the doped polycrystal silicon film) and on the electrode 27 of the transfer gate portion as illustrated in Figure 18.

After selectively removing predetermined parts of the PSG film, aluminium film is grown to a thickness of approximately 1.0 µm by a conventional sputtering process. The aluminium film is further processed to provide a word line 30 and other wirings (Figure 19).

In the particularly described embodiments of the present invention, tantalum was selected, by way of example, as a metal to be used in forming an insulating film of the capacitor element. It is also possible to form an insulating film of high dielectric constant using, for example, titanium oxide, hafnium oxide, niobium oxide, zirconium oxide, alumina, etc, employing metals such as Ti, Hf, Nb, Zr, Al, and so forth, and to secure the same aeffects as have been described.

Insulating films formed using any one of the indicated metals may have a lower withstand voltage if subsequently subjected repeatedly to heat treatment at high temperatures. In order to overcome this possible problem, insulating films containing the indicated metals may be provided in multiple layer form, with layers piled one upon another, or a thin film of silicon nitride ($Si_3N_4$) may be deposited on the insulating film to provide a device having improved characteristics.

Phosphorus is not the only impurity material which can be included in the insulating film. Other materials may also be used, for example by inclusion in the gaseous atmosphere used when forming the film; for instance arsenic, which can easily be introduced into the insulating film may also be used in carrying out a method embodying the present invention.

As has been described above, a region of a conductivity type opposite to that of a semiconductor substrate on which an MIS capacitor element is to be fabricated is formed in precise alignment in a device embodying the present invention. An insulating film of a capacitor element is formed of a metal oxide such as $Ta_2O_5$, which contrasts with the $SiO_2$ film used previously. The insulating film in an embodiment of this invention has a higher dielectric constant, which serves to permit reduction of the area occupied by a capacitor element. The insulating film is doped with an impurity material, and because of this the grain size of the film is smaller than if the insulating film were not so doped. This helps to minimise leakage current.

These features make it possible to enhance the function density of MIS type capacitors as well as improving characteristics of the capacitor.

A semiconductor device embodying the present invention, such as an MIS type capacitor, comprises a semiconductor substrate of one conductivity type (e.g. p-type silicon substrate), a region (e.g. n-type), of a conductivity type opposite to that of the substrate, formed in the substrate, an electrode making up a capacitor formed on the susbtrate apart from the region of opposite conductivity type, and a transfer gate formed between the capacitor and the region of opposite conductivity type. The device is fabricated in accordance with an embodiment of the invention such that the insulating film is formed under the electrode so as to have substantially the same planar form as the electrode, the insulating film contains impurities of a conductivity type opposite to that of the substrate and the region of opposite conductivity type is formed where the insulating film is in contact with the substrate. The region of opposite conductivity type is formed accurately in a self-alignment fashion. Such insulating film is made of an oxide or a nitride of at least one metal selected from the group:— Ta, Ti, Hf, Nb, Zr and Al.

An embodiment of the present invention provides a semiconductor device comprising a semiconductor substrate of one conductivity type in which is formed a region of a conductivity type opposite to that of said substrate, an electrode constituting a capacitor formed over said substrate at a position apart from said region and a transfer gate formed between said capacitor and said region of opposite conductivity type, said device is characterised in that said capacitor comprises an insulating film formed under said electrode in substantially the same planar shape as said electrode, said film containing impurities of a conductivity type opposite to that of said substrate, and a region of said opposite conductivity type formed in said substrate where said insulating film is in contact with said substrate.

In such a semiconductor device the said insulating film may comprise principally an oxide of at least one metal selected from a group comprising tantalum, titanium, hafnium, niobium, zirconium and aluminium.

To form such a semiconductor device said insulating film may be treated first at a temperature within the range of 500 to 700°C to form an oxide of at least one of said metals, then at approximately 1000°C to form said region of opposite conductivity type.

In a semiconductor device embodying this invention, said region of opposite conductivity type may be formed in a self-alignment fashion when a heat treatment is carried out after patterning of said insulating film.

**Claims**

1. A method of manufacturing a semiconductor device having a semiconductor substrate (21) of one conductivity type in which a region (25) of an opposite conductivity type is formed, and having an electrode (24) of a capacitor of the device formed over the substrate (21) spaced apart from the said region (25), wherein an insulating film (23) principally comprising an oxide or a nitride of at least one of the following metals:— tantalum titanium hafnium niobium zirconium aluminium, and containing impurities of the said opposite conductivity type, is formed on the substrate (21) and the said region (25) of the said opposite conductivity type is formed in the substrate (21) where the insulating film (23) contacts the substrate (21) by diffusion of the said impurities from the insulating film (23) into the substrate (21).

2. A method as claimed in claim 1, wherein the insulating film (23) is formed by depositing one of the said metals, and heat treating the deposited metal at a temperature within the range 500°C to 700°C to form an oxide of the metal.

3. A method as claimed in claim 2, wherein the said one of the said metals is deposited by a process such that the said impurities are contained in the metal as deposited.

4. A method as claimed in claim 1, wherein the insulating film (23) is formed by depositing an oxide of one of the said metals by a process such that the said impurities are contained in the oxide as deposited.

5. A method as claimed in claim 1, wherein the insulating film (23) is formed by depositing one of the said metals, and treating the deposited metal in an atmosphere of nitrogen to form a nitride of the metal.

6. A method as claimed in claim 2 or 3, wherein the said region (25) is formed in a heat treatment, subsequent to the heat treatment to form the oxide of the metal, at a temperature of approximately 1000°C.

7. A method as claimed in any preceding claim, the device having a further region (31) of the said opposite conductivity type formed in the susbtrate (21) and a transfer gate (28) formed between the said capacitor and the said further region (31), the insulating film (23) being of substantially the same planar configuration as the said electrode (24).

8. A method as claimed in any preceding claim, wherein the said impurities are of phosphorus or arsenic.

9. A method as claimed in any preceding claim, wherein the electrode (24) is of molybdenum silicide or polycrystalline silicon.

## Patentansprüche

1. Verfahren zur Herstellung einer Halbleitervorrichtung, die ein Halbleitersubstrat (21) von einem Leitfähigkeitstyp hat, in dem ein Bereich (25) von entgegengesetztem Leitfähigkeitstyp geformt ist, und bei der eine Elektrode (24) eines Kondensators der Vorrichtung über dem Substrat (21) mit Abstand von dem genannten Bereich (25) gebildet ist, bei welchem ein isolierender Film (23), der hauptsächlich ein Oxid oder ein Nitrid von wenigstens einem der folgenden Metalle umfaßt:— Tantal, Titan, Hafnium, Niob, Zircon, Aluminium, und der Verunreinigungen von dem genannten entgegengesetzten Leitfähigkeitstyp enthält, auf dem Substrat (21) gebildet wird und der genannte Bereich (25) von dem genannten entgegengesetzten Leitfähigkeitstyp in dem Substrat (21), wo der isolierende Film (23) das Substrat (21) kontaktiert, durch Diffusion der genannten Verunreinigungen von dem isolierenden Film (23) in das Substrat (21) gebildet wird.

2. Verfahren nach Anspruch 1, bei welchem der isolierende Film (23) durch Niederschlagen eines der genannten Metalle und durch Wärmebehandlung des niedergeschlagenen Metalls bei einer Temperatur im Bereich zwischen 500°C bis 700°C gebildet wird, um ein Oxid des Metalls zu bilden.

3. Verfahren nach Anspruch 1 oder 2, bei welchem das genannte eine der genannten Metalle durch ein Verfahren so niedergeschlagen wird, daß die genannten Verunreinigungen in dem Metall, wie es niedergeschlagen wird, enthalten sind.

4. Verfahren nach Anspruch 1, bei welchem der isolierende Film (23) durch Niederschlagen eines Oxids von einem von den genannten Metallen durch ein Verfahren so gebildet wird, daß die genannten Verunreinigungen in dem Oxid, wie es niedergeschlagen wird, enthalten sind.

5. Verfahren nach Anspruch 1, bei welchem der isolierende Film (23) durch Niederschlagen eines der genannten Metalle und durch Behandlung des niedergeschlagenen Metalls in einer Atmosphäre aus Stickstoff gebildet wird, um ein Nitrid des Metalls zu bilden.

6. Verfahren nach Anspruch 2 oder 3, bei welchem der genannte Bereich (25), nach der Wärmebehandlung zur Bildung des Oxids des Metalls, durch eine Wärmebehandlung bei einer Temperatur von etwa 1000°C gebildet wird.

7. Verfahren nach einem der vorhergehenden Ansprüche, bei welchem die Vorrichtung ferner einen Bereich (31) von dem genannten entgegengesetzten Leitfähigkeitstyp hat, der in dem Substrat (21) gebildet ist, und ein Transfergate (28), das zwischen dem genannten Kondensator und dem genannten weiteren Bereich (31) gebildet ist, wobei der isolierende Film (23) von im wesentlichen derselben planaren Konfiguration wie die genannte Elektrode (24) ist.

8. Verfahren nach einem der vorhergehenden Ansprüche, bei welchem die genannten Verunreinigungen aus Phosphor oder Arsen sind.

9. Verfahren nach einem der vorhergehenden Ansprüche, bei welchem die Elektrode (24) aus Molybdänsilizid oder aus polykristallinem Silizium besteht.

## Revendications

1. Procédé de fabrication d'un dispositif semiconducteur comprenant un substrat semiconducteur (21) d'un premier type de conductivité dans lequel une région (25) du type de conductivité opposé est formée, et comprenant une électrode (24) d'un condensateur du dispositif formée sur le substrat (21) espacée de ladite région (25), dans lequel une couche isolante (23) comprenant principalement un oxyde ou un nitrure d'au moins l'un des métaux suivants: tantale, titane, hafnium, niobium, zirconium, aluminium, et contenant des impuretés du type de conductivité opposé est formée sur le substrat (21) et dans lequel ladite région (25) du type de conductivité opposé est formée dans le substrat (21) là où la couche isolante (23) est en contact avec le substrat (21) par diffusion des impuretés à partir de la couche isolante (23) dans le substrat (21).

2. Procédé selon la revendication 1, dans lequel la couche isolante (23) est formée par dépôt de l'un desdits métaux et traitement thermique du métal déposé à une température comprise dans la gamme de 500°C à 700°C pour former un oxyde de ce métal.

3. Procédé selon la revendication 2, dans lequel l'un desdits métaux est déposé par un procédé tel que des impuretés sont contenues dans le métal tel que déposé.

4. Procédé selon la revendication 1, dans lequel la couche isolante (23) est formée par dépôt d'un oxyde de l'un desdits métaux par un procédé tel que les impuretés sont contenues dans l'oxyde tel que déposé.

5. Procédé selon la revendication 1, dans lequel la couche isolante (23) est formée par dépôt de l'un desdits métaux et traitement du métal déposé dans une atmosphère d'azote pour former un nitrure du métal.

6. Procédé selon l'une des revendications 2 ou 3, dans lequel ladite région (25) est formée par traitement thermique, après le traitement thermique de formation de l'oxyde du métal, à une température d'environ 1000°C.

7. Procédé selon l'une quelconque des revendications précédentes, le dispositif comprenant une autre région (31) du type de conductivité opposée formée dans le substrat (21) et une grille de transfert (28) formée entre ladite condensateur et ladite autre région (31), la couche isolante (23) ayant sensiblement la même configuration en plan que ladite électrode (24).

8. Procédé selon l'une quelconque des revendications précédentes, dans lequel les impuretés sont du phosphore ou de l'arsenic.

9. Procédé selon l'une quelconque des revendications précédentes, dans lequel l'électrode (24) est en siliciure de molybdène ou en silicium polycristallin.

F I G. 1

FIG. 2

FIG. 3

FIG·4

FIG·5

FIG·6

FIG·7

FIG·8

FIG.9

0 055 558

FIG·10

0 055 558

FIG·11

FIG·12

FIG·13

FIG·14

FIG·15

FIG·16

5

**0 055 558**

FIG·17

FIG·18

FIG·19

6